# EUROPEAN PATENT APPLICATION

(11) **EP 3 073 747 A1**
(43) Date of publication of application: **28.09.2016**
(21) Application number: 15305443.2
(22) Date of filing: 26.03.2015
(51) Int. Cl.: H04N 21/4223, H04N 21/439, H04N 21/442, H04N 7/00, H03G 3/30, G06F 3/16, G06K 9/22, G10L 21/0316

(54) **METHOD AND DEVICE FOR ADAPTING AN AUDIO LEVEL OF A VIDEO**

(71) Applicant: Thomson Licensing, 92130 Issy-les-Moulineaux (FR)
(72) Inventor: Jouet, Pierrick, 35576 CESSON-SÉVIGNÉ (FR); Baillard, Caroline, 35576 CESSON-SÉVIGNÉ (FR); Alleaume, Vincent, 35576 CESSON-SÉVIGNÉ (FR)
(74) Representative: Barr, Angela Louise

(57) **Abstract**

The disclosure relates to a method for adapting an audio level of a video, comprising:
- identifying (11) at least one person in the video,
- selecting (12) an audio track corresponding to said identified person in the video,
- adjusting (13) the audio level of said selected audio track, as a function of at least one control parameter.

## Description

### 1. Technical field

The present disclosure relates to the field of signal processing, and more specifically to the processing of sequences of images, also called video.

The present disclosure sets out to provide a technique for improving the audio quality of videos, by adjusting the audio level of a video.

The present disclosure is particularly adapted to any applications related to video rendering, for example on mobile devices.

### 2. Background art

This section is intended to introduce the reader to various aspects of art, which may be related to various aspects of the present disclosure that are described and/or claimed below. This discussion is believed to be helpful in providing the reader with background information to facilitate a better understanding of the various aspects of the present disclosure. Accordingly, it should be understood that these statements are to be read in this light, and not as admissions of prior art.

It is becoming increasingly common for users to make their own videos, using their smart phone, tablet, or camera for example. Lots of them are then posted on social networks.

However, as these videos are often captured in a noisy environment (for example when several people are talking, during parties, ...), they do not present a good audio quality.

### 3. Summary

A first aspect of the invention provides a method for adapting an audio level of a video, comprising:
- identifying at least one person in the video,
- selecting an audio track corresponding to said identified person in the video,
- adjusting the audio level of said selected audio track, as a function of at least one control parameter.

The present disclosure thus proposes a new technique for improving the audio quality of videos.

More specifically, the present disclosure sets out to provide a solution to adapt the audio level of an audio track, as a function of at least one control parameter, such as, for example, the position of an identified person in the video.

In this way, the audio level of the audio track associated with the person of interest will be higher than the audio level of the other audio tracks, and it will be easier to understand the person of interest, even in a noisy environment.

The present disclosure thus introduces new audio/video special effects.

According to at least one embodiment, identifying at least one person in the video implements a recognition technique based on statistical face models.

Such recognition techniques based on statistical face models are very efficient in identifying a person, even when the person is not face-on.

According to at least one embodiment, selecting an audio track corresponding to said identified person in the video comprises:
- separating the audio sources of the video to provide at least one audio track,
- obtaining a voice model of said identified person, and
- identifying, from among said at least one audio track, an audio track associated with said voice model to provide said selected audio track.

According to this embodiment, audio source separation is first used to separate the different audio tracks. Then the audio track corresponding to the identified person is selected, using a voice model (such as a voice signature) of the identified person.

According to at least one embodiment, the control parameter belongs to the group comprising:
- a position of the identified person in at least one image of the video,
- a ratio of the size of the identified person within at least one image of the video compared to the size of the at least one image,
- a distance of the identified person from a device capturing the video,
- a trajectory of the device capturing the video,
- a zoom of the device capturing the video,
- etc.

It is thus possible to adapt the audio level according to one or more control parameters. In others words, the position of the identified person in the image plane, the distance from the camera, the trajectory of the camera, a zoom (backward, forward), the center of interest (focus), etc., can be used as inputs to control the audio level.

In particular, the ratio of the size of the identified person within at least one image of the video could be modified when the distance of the identified person from a device capturing the video and/or a zoom of the device capturing the video is/are changed.

According to at least one embodiment, the method comprises obtaining a database of at least one face model and at least one corresponding voice model.

For example, such a database could be obtained during a preliminary training step.

This training step could be implemented in real time or off-line, in order to obtain a set of face models regarding, for example, the family members, friends, etc, of the owner of the video.

In particular, said at least one face model is a 2D or 3D face model.

As already mentioned, such 3D face models are particularly efficient for identifying a person even is the person is not face-on.

A second aspect of the invention provides a device for adapting an audio level of a video, comprising at least one processor configured to:
- identify at least one person in the video,
- select an audio track corresponding to said identified person in the video, and
- adjust the audio level of said selected audio track, as a function of at least one control parameter.

A further aspect of the invention provides a device comprising a display for displaying a video an audio output for outputting audio data associated with the video; at least one processor in communication with the display and the audio output and at least one memory in communication with the processor, the memory including instructions that when executed by the processor cause the device to perform operations including
- identifying at least one person in the displayed video,
- selecting an audio track corresponding to said identified person in the video, and
- adjusting the audio level of said selected audio track for output by the audio output, as a function of at least one control parameter.

Such a device can be especially adapted to implement the method for adapting an audio level of a video described here above. It could of course comprise the different characteristics pertaining to the method according to an embodiment of the disclosure, which can be combined or taken separately. Thus, the characteristics and advantages of the device are the same as those of the method and are not described in more ample detail.

Another aspect of the disclosure pertains to a computer program product downloadable from a communication network and/or recorded on a medium readable by computer and/or executable by a processor comprising software code adapted to perform a method for adapting an audio level of a video, wherein the software code is adapted to perform the steps of the method for adapting an audio level of a video described above.

In addition, the present disclosure concerns a non-transitory computer readable medium comprising a computer program product recorded thereon and capable of being run by a processor, including program code instructions for implementing the steps of the method for adapting an audio level of a video previously described.

Certain aspects commensurate in scope with the disclosed embodiments are set forth below. It should be understood that these aspects are presented merely to provide the reader with a brief summary of certain forms the disclosure might take and that these aspects are not intended to limit the scope of the disclosure. Indeed, the disclosure may encompass a variety of aspects that may not be set forth below.

### 4. Brief description of the drawings

The disclosure will be better understood and illustrated by means of the following embodiment and execution examples, in no way limitative, with reference to the appended figures in which:
- Figure 1 is a flow chart illustrating the main steps of a method for adapting an audio level of a video according to an embodiment of the disclosure;
- Figure 2 depicts an example of database according to an embodiment of the disclosure;
- Figure 3 illustrates a specific embodiment of the method for adapting an audio level of a video; and
- Figure 4 is a block diagram of a device implementing the method for adapting an audio level of a video according to Figure 1.

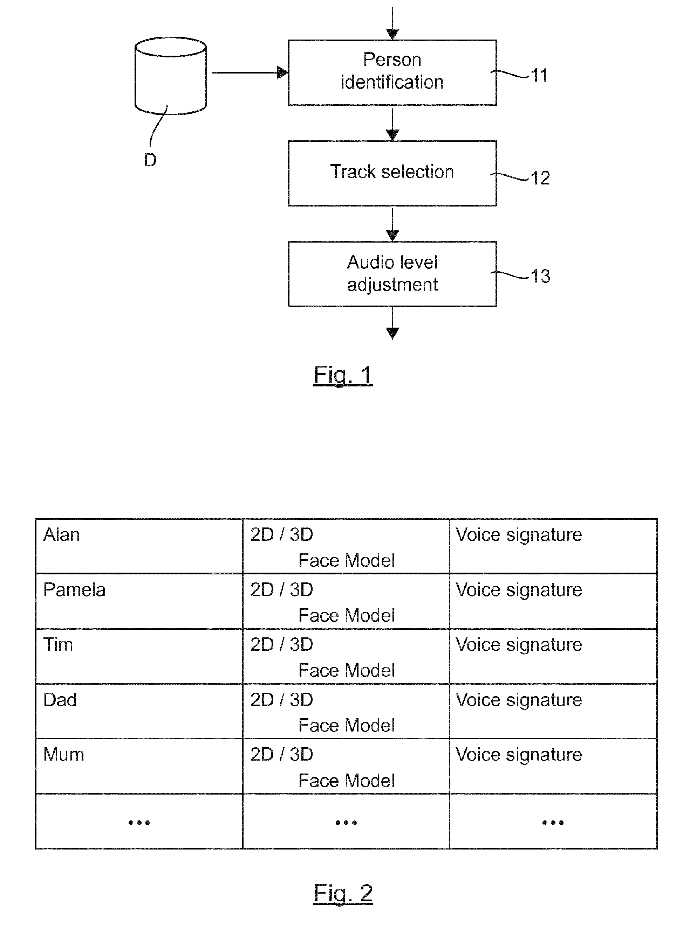

In Figures 1, 3 and 4, the represented blocks are purely functional entities, which do not necessarily correspond to physically separate entities. Namely, they could be developed in the form of software, hardware, or be implemented in one or several integrated circuits, comprising one or more processors.

### 5. Description of embodiments

It is to be understood that the figures and descriptions of the present disclosure have been simplified to illustrate elements that are relevant for a clear understanding of the present disclosure, while eliminating, for purposes of clarity, many other elements found in typical display devices.

The present disclosure proposes a new technique for improving the audio quality of videos.

The main steps of the method for adapting an audio level of a video according to an embodiment of the invention are illustrated in **Figure 1****.**

A video, with audio, is considered as input. Such a video may for example be captured by a mobile device, such as a smart phone, a tablet or a camera, in a noisy environment, and rendered either on the capturing device or on another device (for example after the video has been posted on a social network).

During a first identification step 11, at least one person is identified in the video.

The identification step implements, for example, a recognition technique based on statistical face models. Such recognition techniques are well-known, and are described for example in the document *"Video-Based Face Recognition Using Adaptive Hidden Markov Models"* (Xiaoming Liu and Tsuhan Chen, Electrical and Computer Engineering, Carnegie Mellon University, Pittsburgh, PA, 15213, U.S.A.).

As a reminder, a statistical face model is built from a set of images or videos, and stored in a database. During the recognition process, features of at least one image of the video are compared to the face models stored in the database, in order to identify at least one person.

A face model could currently be a 2D model or a 3D model.

With a 2D face model, better recognition performances are obtained with frontal views (or face-on views) of the persons to identify in the video. Rotations other than those in the image plane are hardly supported. To improve the success ratio, non-frontal views of the persons to identify can be added to the database.

To avoid these problems, it is also possible to use 3D face models. To build 3D face models, texture and depth maps (issued from a stereo system for example) may typically be used. For 3D face model, a signature could be defined by a set of features (for instance a global shape and appearance feature may be computed, from combined and discriminating local shape and/or texture features).

Before the first identification step 11, a database D comprising at least one face model can thus be obtained to implement a recognition technique based on statistical face models.

For example, such database D of face models can be built during a training step. Indeed, many videos captured by a user include family members and friends, and it is easy for the user to associate a face model with such a family member or friend in the database. The assumption may thus be made that the owner of the video has access to a set of face models, corresponding to family members, friends, etc.

At the end of the first identification step 11 according to this embodiment, at least one person figuring in the video and whose face model is stored in the database is identified.

In alternative embodiments, other recognition techniques not based on statistical face models can be implemented during the first identification step 11. Such techniques are for example described in *"Local Gabor Binary Pattern Histogram Sequence (LGBPHS): A Novel Non-Statistical Model for Face Representation and Recognition"* (Wenchao Zhang et al.).

Once at least one person has been identified in the video during identification step 11, an audio track corresponding to the identified person in the video is selected during a selection step 12.

The selection step 12 implements, for example, a well-known audio source separation process, in order to obtain a first track corresponding to a first voice, possibly a second track corresponding to a second voice, possibly a third track corresponding to music or surrounding noise, etc.

It is then possible to identify the audio track associated with the identified person using a speaker recognition technique such as described by Campbell et al. in "SVM based speaker verification using a GMM Supervector kernel and NAP variability compensation" (Acoustics, Speech and Signal Processing, 2006) or by Faundez-Zanuy et al. in "State-of-the-art in speaker recognition" (IEEE A&E Systems magazine, May 2005).

For example, the database D of face models also comprises voice models associated with family members, friends, or other person in the database. In other words, each face model is associated with a voice model (for example a signature of the voice of the person associated with this face model) in the database D. An example of such database D is illustrated in **Figure 2****.**

Once an audio track corresponding to the identified person in the video has been selected during the selection step 12, the audio level of the selected audio track is adapted (or tuned) during an adjustment step 13, as a function of at least one control parameter.

Such control parameter belongs to the group comprising:
- a position of the identified person in at least one image of the video,
- a ratio of the size of the identified person within at least one image of the video compared to the size of the at least one image,
- a distance of the identified person from a device capturing the video,
- a trajectory of the device capturing the video,
- a zoom of the device capturing the video,
- etc.

The audio level of the selected audio track can thus be adjusted depending on one or more control parameters. The level of the voice of at least one person identified in the video can be adjusted depending on the trajectory of the device capturing the video (static, moving, zoom, etc), the position of the identified person on the video (ratio person /image, focus, distance from the center of the image....), etc.

For example, if there is a zoom centered on an identified person, the related voice level is increased, whereas the sounds furthest from this location can be decreased in intensity, as if the video viewer was moving through the apparent camera path. This process is particularly helpful in a noisy context.

During movement, it is possible according to the embodiments of the invention to increase the voice level when the identified person is located at the center of an image of the video.

In a 3D application, as the camera path can be modified, it is possible according to an embodiment of the invention to adjust the audio level depending on the new path (for example, by increasing the audio level if the new distance between the camera and the person is less than the previous one).

At least one embodiment of the invention thus proposes an intelligent audio level adjustment.

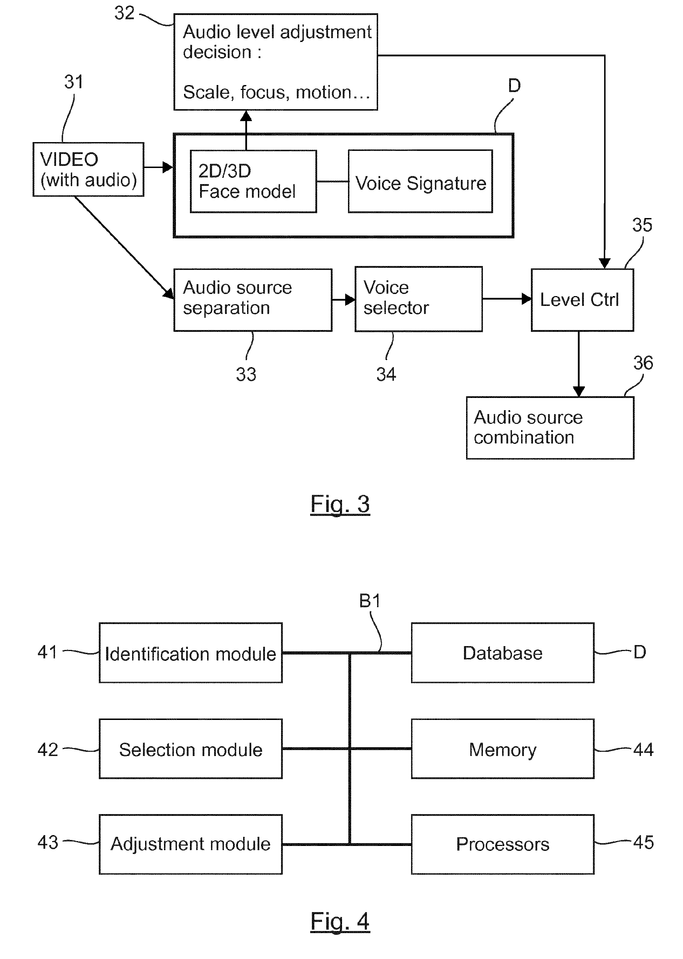

**Figure 3** schematically illustrates a specific embodiment of the method for adapting an audio level of a video.

A video 31 and a database D comprising at least one face model and a signature of the voice of the person associated with this face model, is considered, as illustrated in Figure 2.

The database D could be stored in a memory of the device used to capture the video 31, on another rendering device, or on a remote server.

According to this embodiment, the video 31 is analyzed to identify at least one person in the video, by implementing a recognition process based on the face models stored in the database D. When a person is identified in the video (the person matches a known model), his voice signature is also known, by virtue of the database D.

From the analysis of the video, it is also possible to determine the importance of the identified person in the images of the video, using for instance the identified person occupancy ratio, distance to the center and the camera focus. Such analysis enables control parameters (scale, focus, motion, etc,) to be determined and a decision to be taken on an audio level adjustment 32.

An audio source separation process 33 is also launched. The audio source separation process can be launched in parallel to the recognition process.

Such processes could be implemented in real-time or off-line.

With the voice signature and the result of the audio source separation process 33, it is possible to find the audio track corresponding to the identified person and to select it 34.

The audio level of the selected audio track 34 is then controlled 35, as a function of at least one of the control parameter 32. The audio level of the selected track is thus tuned depending of the processing system inputs.

The different tracks can then be combined 36 to restore the original context.

**Figure 4** schematically illustrates an example of a device for adapting an audio level of a video according to an embodiment of the invention. Such a device is for example implemented in the capturing device, such as a smartphone, a tablet, a camera, etc., which has captured the input video. Only the main elements of the device for adapting an audio level of a video are shown.

Such device comprises at least:
- an identification module 41 for identifying at least one person in the video,
- a selection module 42 for selecting an audio track corresponding to the identified person in the video,
- an adjustment module 43 for adjusting the audio level of the selected audio track, as a function of at least one control parameter,
- optionally a database D, comprising face models and corresponding voice models,
- memory 44, such as a volatile memory,
- one or more processors 45 such as CPUs for executing the applications and programs stored in a non-volatile memory of the device,
- an internal bus B1 to connect the various modules and all means well known to the skilled in the art for performing the device functionalities.

The features of the device are the same as those of the method for adapting an audio level of a video and are not described in more ample detail.

The flowchart and/or block diagrams in the Figures illustrate the configuration, operation and functionality of possible implementations of systems, methods and computer program products according to various embodiments of the present disclosure. In this regard, each block in the flowchart or block diagrams may represent a module, segment, or portion of code, which comprises one or more executable instructions for implementing the specified logical function(s).

For example, identification module 41, selection module 42, and adjustment module 43 may be provided as software components stored in memory of the device. The one or more processing units 45 may be configured to execute the various software programs and/or sets of instructions of the software components to perform the respective functions of: identifying at least one person in the video, selecting the audio track corresponding to the identified person and adjusting the audio level of the selected audio track as a function of at least one control parameter, in accordance with embodiments of the invention.

It should also be noted that, in some alternative implementations, the functions noted in the block may occur out of the order noted in the figures. For example, two blocks shown in succession may, in fact, be executed substantially concurrently, or the blocks may sometimes be executed in the reverse order, or blocks may be executed in an alternative order, depending upon the functionality involved. It will also be noted that each block of the block diagrams and/or flowchart illustration, and combinations of the blocks in the block diagrams and/or flowchart illustration, can be implemented by special purpose hardware-based systems that perform the specified functions or acts, or combinations of special purpose hardware and computer instructions. While not explicitly described, the present embodiments may be employed in any combination or sub-combination.

As will be appreciated by one skilled in the art, aspects of the present principles can be embodied as a system, method, computer program or computer readable medium. Accordingly, aspects of the present principles can take the form of an entirely hardware embodiment, an entirely software embodiment (including firmware, resident software, microcode, and so forth), or an embodiment combining software and hardware aspects that can all generally be referred to herein as a "circuit," "module", or "system." Furthermore, aspects of the present principles can take the form of a computer readable storage medium. Any combination of one or more computer readable storage medium(s) may be utilized.

A computer readable storage medium can take the form of a computer readable program product embodied in one or more computer readable medium(s) and having computer readable program code embodied thereon that is executable by a computer. A computer readable storage medium as used herein is considered a non-transitory storage medium given the inherent capability to store the information therein as well as the inherent capability to provide retrieval of the information therefrom. A computer readable storage medium can be, for example, but is not limited to, an electronic, magnetic, optical, electromagnetic, infrared, or semiconductor system, apparatus, or device, or any suitable combination of the foregoing. It is to be appreciated that the following, while providing more specific examples of computer readable storage mediums to which the present principles can be applied, is merely an illustrative and not exhaustive listing as is readily appreciated by one of ordinary skill in the art: a portable computer disc, a hard disc, a random access memory (RAM), a read-only memory (ROM), an erasable programmable read-only memory (EPROM or Flash memory), a portable compact disc read-only memory (CD-ROM), an optical storage device, a magnetic storage device, or any suitable combination of the foregoing.

## Claims

1. A method for adapting an audio level of a video, comprising:
- identifying (11) at least one person in the video,
- selecting (12) an audio track corresponding to said identified person in the video,
- adjusting (13) the audio level of said selected audio track, as a function of at least one control parameter.

2. The method according to claim 1, wherein identifying (11) at least one person in the video implements a recognition technique based on statistical face models.

3. The method according to claim 1 or 2, wherein selecting (12) an audio track corresponding to said identified person in the video comprises:
- separating the audio sources of the video to provide at least one audio track,
- obtaining a voice model of said identified person, and
- identifying, from among said at least one audio track, an audio track associated with said voice model to provide said selected audio track.

4. The method according to any one of claims 1 to 3, wherein said control parameter belongs to the group comprising:
- a position of the identified person in at least one image of the video,
- a ratio of the size of the identified person within at least one image of the video compared to the size of the at least one image,
- a distance of the identified person from a device capturing the video,
- a trajectory of the device capturing the video, and
- a zoom of the device capturing the video.

5. The method according to any one of claims 1 to 4, wherein it comprises obtaining a database of at least one face model and at least one corresponding voice model.

6. The method according to claim 5, wherein said at least one face model is a 2D or 3D face model.

7. The method according to any one of claims 5 and 6, wherein the database is obtained during a preliminary training step.

8. A device for adapting an audio level of a video, comprising:
- an identification module (41) for identifying at least one person in the video,
- a selection module (42) for selecting an audio track corresponding to said identified person in the video,
- an adjustment module (43) for adjusting the audio level of said selected audio track, as a function of at least one control parameter.

9. The device according to claim 8, wherein said identification module (41) is configured to implement a recognition technique based on statistical face models.

10. The device according to any one of claims 8 and 9, wherein said selection module (42) is configured to:
- separate the audio sources of the video to provide at least one audio track,
- obtain a voice model of said identified person, and
- identify, from among said at least one audio track, an audio track associated with said voice model to provide said selected audio track.

11. The device according to any one of claims 8 to 10, wherein said control parameter belongs to the group comprising:
- a position of the identified person in at least one image of the video,
- a ratio of the size of the identified person within at least one image of the video compared to the size of the at least one image,
- a distance of the identified person from a device capturing the video,
- a trajectory of the device capturing the video, and
- a zoom of the device capturing the video.

12. The device according to any one of claims 8 to 11, comprising a database of at least one face model and at least one corresponding voice model.

13. The device according to claim 12, wherein said at least one face model is a 2D or 3D face model.

14. A computer program product downloadable from a communication network and/or recorded on a medium readable by computer and/or executable by a processor comprising software code adapted to perform a method for adapting an audio level of a video according to anyone of claims 1 to 7 when it is executed by a processor.

15. A non-transitory computer-readable medium comprising a computer program product recorded thereon and capable of being run by a processor, including program code instructions for implementing a method for adapting an audio level of a video according to anyone of claims 1 to 7.
